# EUROPEAN PATENT SPECIFICATION

(11) **EP 0 446 367 B1**
(45) Date of publication and mention of the grant of the patent: **05.02.1997**
(21) Application number: 90913886.9
(22) Date of filing: 21.09.1990
(51) Int. Cl.: G05B 11/01

(54) **CONTROL DEVICE**
STEUERVORRICHTUNG
DISPOSITIF DE COMMANDE

(30) Priority: 04.10.1989 JP 259821/89
(43) Date of publication of application: 18.09.1991
(73) Proprietor: FANUC LTD., Minamitsuru-gun, Yamanashi 401-05 (JP)
(72) Inventor: IMAZEKI, Ryoji, Hachioji-shi Tokyo 192 (JP); KURAKAKE, Mitsuo, Hino-shi Tokyo 191 (JP); YONEKURA, Mikio, c/o FANUC Mansion Harimomi 7-303, Minamitsuru-gun, Yamanashi 401-05 (JP)
(74) Representative: Brunner, Michael John
(86) International application number: JP9001223
(87) International publication number: WO9105292

(56) References cited:
- EP-A- 0 349 878
- JP-A- 5 539 635
- JP-A-58 123 799
- JP-Y- 0 608 463
- JP-Y- 6 210 805
- US-A- 4 771 366

## Description

The present invention relates to a control apparatus such as a numerical control apparatus and the like, and more specifically, to a control apparatus having reduced external dimensions obtained particularly by high density mounting.

In a control apparatus such as a numerical control apparatus, various circuit components including a microprocessor are mounted on a printed circuit board, a plurality of the printed circuit boards on which these circuit components are mounted are inserted to a rack, and the printed circuit boards are electrically interconnected through back planes and cables to form a control system.

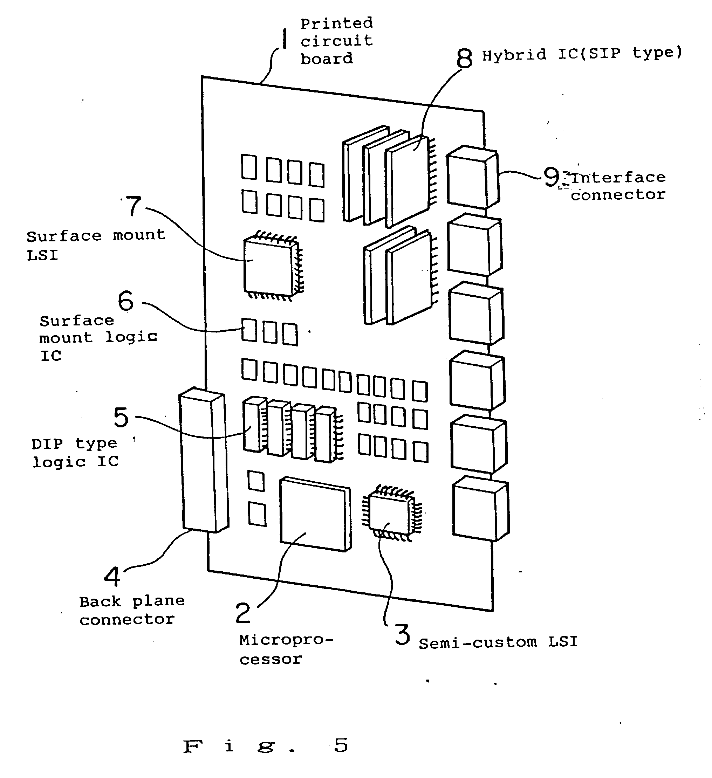

Figure 5 is a diagram showing a printed circuit board on which various circuit components are mounted. The printed circuit board has a size of 310 x 150 mm, and many circuit components such as a microprocessor 2, a semi-custom LSI 3, a back plane connector 4, DIP (dual in-line) type logic ICs 5, surface mount logic ICs 6, a surface mount LSI 7, SIP (single in-line) type hybrid ICs 8 and the like are mounted on thereon.

Interface connectors 9 are mounted at the edge of the front surface side of the printed circuit board 1 to enable connections to external devices, and electric signals are obtained therefrom through a cable.

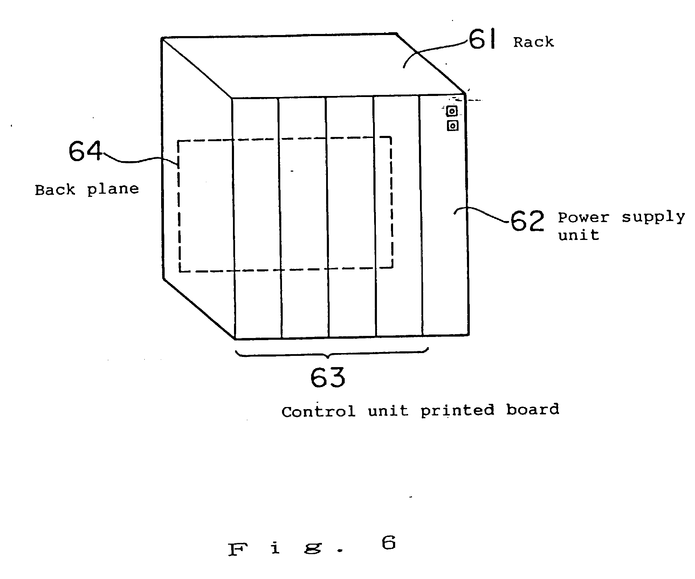

Figure 6 is a diagram showing the schematic arrangement of a conventional control apparatus, wherein a power supply unit 62 and various control unit printed boards 63 are mounted on a rack 61. As shown in Figure 5, each of the control unit printed boards has the various circuit components mounted thereon, and the control unit print boards are interconnected by connecting each of the back plane connectors 4 thereof to a back plane 64.

Although many circuit components are mounted on each printed circuit board, the size of each of the circuit components has been reduced due to improvements in surface mounting technologies, and accordingly the mounting density of the components also has been greatly improved.

A semi-custom LSI such as a gate array and standard cell can be easily made by an LSI technology and thus a circuit conventionally made of discrete components can be produced as one chip.

The hybrid IC8 has been conventionally used as a technology for integrating many surface mount components, printed resistance elements, and bare chip ICs (ICs before molding). In particular, a SIP (single in-line) type package is advantageous in that it can be vertically mounted on a printed circuit board and occupies a very small area of the printed circuit board, and thus has been used particularly in many applications as a mounting technology for a control apparatus.

Further, the external dimensions of the interface connector 9 to the external devices have been reduced by a method of reducing a contact pitch and the like, and accordingly, this has contributed to a reduction of the size of the control apparatus, together with the use of the surface mount technology, semi-custom LSI technology and hybrid IC technology.

A control apparatus having a small size provides a user with a great advantage in that the space needed for installation is reduced. Further, when the size of the control apparatus is reduced, the cost thereof is generally reduced and the processing capacity thereof can be improved. Therefore, the reduction in size of the control apparatus is an effective method from the view point of cost and performance.

Further, when the control apparatus has a reduced size, a distance between a plurality of subsystems constituting the control apparatus is shortened and a time needed to transfer and receive a signal is accordingly reduced, to thereby further improve performance.

As described above, the reduction in size of the control apparatus provides various advantages and the size thereof can be reduced by employing various technologies. Nevertheless, the use of the conventional technologies alone limits the reduction of the size of the control apparatus, for the reasons given below, and a further reduction in size has not been possible.

A first reason for the above-mentioned limitations is that a mixed mounting of low surface mount components and high components mounted generally lowers the mounting efficiency.

In general, it can be taken that, when a ratio of a space actually occupied by components to a space occupied by a printed circuit board in an apparatus is larger, the space mounting efficiency is improved. In the conventional mounting technologies, however, components having different heights are mounted on the same printed circuit board, and thus this assumption is negated.

For example, a logic circuit IC and memory IC have a heigbt of about 2 - 3 mm, whereas an interface connector has a height of about 10 mm, and in particular, a single in-line type hybrid IC usually has a height of 15 - 30 mm. The printed circuit board on which such components having different heights are mounted, as described above, occupies a space determined by the highest component in the apparatus, and thus the mounting efficiency is greatly reduced.

A printed circuit board such as a memory board does not need an interface to external devices, and further, a hybrid IC and the like are not usually employed in combination therewith. Therefore, in the case of a memory board, a thin board having an improved space mounting efficiency can be made by surface mounting memory ICs on the entire surface of the printed circuit board.

Unlike a computer used in an office, however, a control apparatus receives an input from and transfers an output to many external devices, for different purposes, and includes many interface connectors wherein in many cases the interface circuit is composed of hybrid ICs. Therefore, the printed circuit board used for the control apparatus must be provided with many kinds of high components mounted thereon, with the result that any improvement in the space mounting efficiency becomes difficult, and thus a reduction in the size of the control apparatus is limited.

A second reason is that the control apparatus is provided with many interface connectors for receiving inputs from, and transferring outputs, to external devices.

The printed circuit board of the control apparatus inevitably includes a control circuit for a certain function, and has an interface connector corresponding thereto mounted thereon. Here, as is obvious, it is economical to mount as many functions as possible, depending on the area of the printed circuit board.

On the other hand, the size of the control circuit can be reduced by the use of the surface mounting technology, semi-custom LSI technology and hybrid IC technology, whereas the size of the interface connector cannot be reduced in the same way as an electric circuit, because it is a mechanical component. Further, the number of connectors that can be mounted on a single printed circuit board is limited.

Therefore, regardless of the reduction in size of the control circuit, in many cases it is difficult to integrate many functions on a single printed circuit board in many cases because the number of interface connectors mounted on a single printed circuit board is limited.

A third reason is that the surface mount technology cannot be applied to some of the printed circuit boards constituting the control apparatus.

To reduce the size of the control apparatus, it is essential to mount as many components as possible on a single printed circuit board, and the surface mount technology is very effective in this respect.

Nevertheless, it is difficult to surface mount all of the components on the printed circuit. For example, a mechanical component such as an interface connector, which must withstand the application of an external force, accordingly must have a predetermined higher mechanical strength. Therefore, the surface mount technology is not applicable because it cannot provide a sufficient strength, and thus the mechanical component must be mounted by a conventional method, i.e., inserting leads into a through hole and soldering.

Further, some of semiconductor elements used in a high speed circuit and interface circuit produce a large amount of heat, and thus a problem arises in that, when mounted as a surface mount component, the junction temperature increases, which lower the reliability thereof because the surface mount component has a small heat radiation area.

Therefore, the surface mount technology cannot be applied to these elements, and a conventional insert mount package inevitably must be used.

As described above, the actual process of making the printed circuit board is such that a mixture of surface mount components and insert mount components are mounted on the printed circuit board and a dip soldering process is carried out in a solder bath (a surface to be soldered is dipped in melted solder) in addition to a surface mount process.

When components can be mounted on both surfaces of the printed circuit board, the mounting density can be greatly increased, and thus logic ICs and memory ICs are preferably mounted on both entire surfaces of the printed circuit board. Surface mount components withstanding the dip soldering process are limited to such components as chip resistors and chip capacitors and, therefore, it is difficult in practice to surface mount all of the components, and to utilize both surfaces of the printed circuit board for mounting these components.

US-A-4771366 shows a system motherboard for a computer in which circuit cards having memory packages mounted thereon are fixed to the motherboard, whereby the apparatus includes module boards having circuit components mounted thereon, the module boards being mounted on the printed circuit boards in such a manner that the mounting surface of each of the module boards is perpendicular to the mounting surface of the printed circuit boards.

Taking the above into consideration, an object of the present invention is to provide a control apparatus comprising circuit components having an improved mounting density and having reduced external dimensions.

According to the present invention, there is provided a control apparatus comprising a plurality of printed circuit boards, the apparatus being characterized by :
elongate I/O interface connectors mounted on the printed circuit boards in such a manner that the long direction thereof is perpendicular to the mounting surface of the printed circuit boards, wherein the height of the module boards from the printed circuit boards is substantially the same as the height of the interface connectors from the surface of the printed circuit boards.

Many interface connectors can be mounted at the front end of the printed circuit board by an arrangement such that each of the I/O interface connectors is mounted on the printed circuit board so that the long direction thereof is perpendicular to the mounting surface of the printed circuit board, and thus many circuit components for processing input and outputs can be mounted on a single printed circuit board. The circuit components are mounted on the module board, which is mounted on the printed circuit board so that the mounting surface thereof is perpendicular to the mounting surface of the printed circuit board and, with this arrangement, many module boards can be mounted on a single printed circuit board. The height of the module board from the surface of the printed circuit board is made to be substantially the same as the height of the interface connector from the printed circuit board. With this arrangement, the amount of the circuit components that can be mounted in a unit space is increased, thereby to reduce the size of the control apparatus as a whole.

In the drawings:
Figure 1 is a diagram showing the structure of a printed circuit board constituting a numerical control apparatus as an embodiment according to the present invention;
Figure 2 is a diagram showing the detail of a module board of Figure 1;
Figure 3 is an enlarged diagram showing the mounting state of an interface connector of Figure 1.
Figure 4 is a diagram showing the outside appearance of a control apparatus using the printed circuit board shown in Figure 1;
Figure 5 is a diagram showing a printed circuit board on which various circuit components are mounted; and
Figure 6 is a diagram showing the schematic arrangement of a conventional control apparatus.

An embodiment of the present invention will be described below with reference to the drawings.

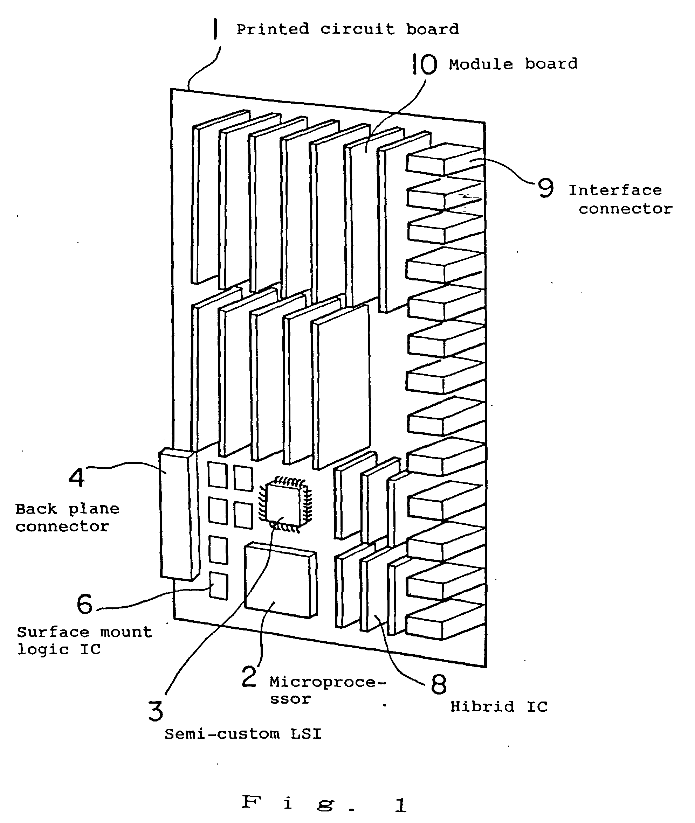

Figure 1 is a diagram showing the structure of a printed circuit board constituting a numerical control apparatus as an embodiment according to the present invention. The printed circuit board has a size of 310 x 150 mm. Circuit components such as a microprocessor 2, a semi-custom LSI 3, a back plane connector 4, surface mount logic ICs 6, SIP (single in-line) type hybrid ICs 8 and the like are mounted on the printed circuit board 1, and a plurality of module boards 10 are provided on the printed circuit board through module sockets (not shown) provided on the upper side of these circuit components. Insert mount components such as a clock oscillator, a standard TTL and the like are mounted on these module boards 10.

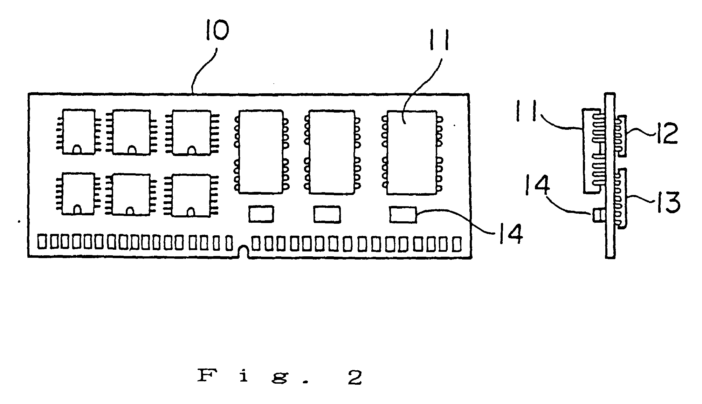

Figure 2 is a diagram showing the detail of the module board of Figure 1.

The module board 10 is 100 mm in width and 40 mm in height and surface mount components 11, 12, 13 and 14 are mounted on both surfaces thereof. The module board 10 is mounted in such a manner that the mounting surface thereof is perpendicular to the mounting surface of the printed circuit board 1.

A pad for a 78 pin card edge connector (conductor for connecting signals) is formed at the edge of and in the lengthwise direction of the module board 10. The insertion of the pad portion of the module board 10 to a module socket mounted on the printed circuit board 1 enables the module board 10 to be mechanically and electrically connected to the printed circuit board 1, and a signal connection between a plurality of the module boards 10 and signal connections between the module board 10 and the interface connectors 9 are carried out by a printed wiring provided on the printed circuit board 1 main body.

A conventional module board arranged as described above has only memories mounted thereon, as in a DRAM module, but when a semiconductor manufacturer intends to supply a plurality of ICs assembled and mounted on a single module, an essential condition for promoting a sufficient demand for the module is that the module can be applied for a general purpose use. This condition can be satisfied only by a memory module, even if ICs are arranged as a module, and therefore, even if circuits other than a memory are arranged as a module, the module does not have sufficient high general-purpose properties that will encourage users to employ these module.

In contrast to the above, the present invention does not intend to pursue the obtaining of general-purpose properties by an arrangement such as a module, but is intended to effectively utilize both surfaces of the module board, and further, effectively utilize a mounting space of the printed circuit board main body by an arrangement thereof as a module.

As described above, a first feature of the present invention is that the following functions, including a memory, are arranged as modules and these modules are mounted perpendicularly to the surface of the printed circuit board 1.

Note, the circuit components mounted on the module board must be arranged so that they satisfy the condition that the number of signal connections thereof is at least a predetermined number. More specifically, one function was conventionally realized by a single printed circuit board, but the present embodiment is arranged to realize one function by a plurality of module boards, and thus the number of signal lines from the module board must not exceed the number of pads of the module board. Thus, preferably each module is schematically arranged as described below.

A first module includes a power on clear circuit, a timer circuit, an interrupt control circuit, and a memory battery back up control circuit arranged as a module; a second module includes SRAMs and a parity check circuit arranged as a module; a third module includes EPROMs arranged as a module; a fourth module includes a communication control circuit, a driver/receiver circuit, manual pulse generator, and an interface circuit arranged as a module; a fifth module includes a CRT display control circuit arranged as a module; a sixth module includes a digital servo control circuit composed of a processor, a memory, LSIs for a control circuit and the like arranged as a module; a seventh module includes a spindle amplifier interface circuit arranged as a module; and an eighth module Includes an I/O link Interface circuit and a sequence control circuit arranged as a module.

A second feature of the present invention is that the interface connector 9 is mounted in such a manner that the lengthwise direction thereof is perpendicular to the surface of the printed circuit board 1.

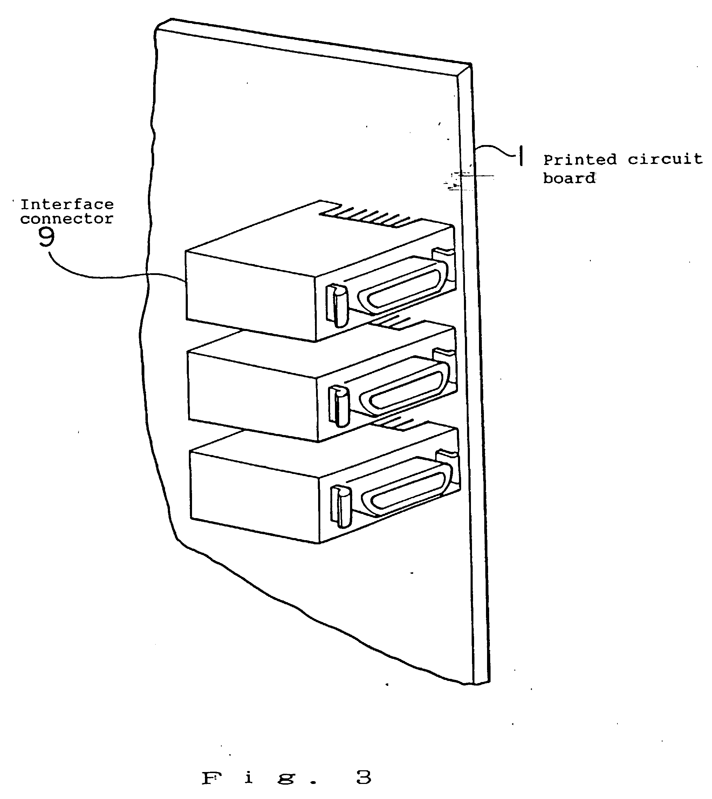

Figure 3 is an enlarged diagram showing the mounting state of the interface connector of Figure 1. As apparent from the figure, the interface connector 9 is mounted such that the long direction thereof is perpendicular to the mounting surface of the printed circuit board 1.

A shown in Figure 5, a conventional interface connector was mounted such that the lengthwise direction thereof was parallel to the mounting surface of the printed circuit board, and therefore, conventionally the number of interface connecters mounted on the front edge of a single printed circuit board was limited to about 6 units, and thus the number of modules to be mounted was limited by the number of the interface connectors 9, regardless of how many modules could be mounted on the single printed circuit. board.

In contrast to the above, according to the present invention, since the interface connector 9 is mounted such that the lengthwise direction thereof is perpendicular to the mounting surface of the printed circuit board 1, a ratio of the length of the interface connector 9 occupying the front end of the printed circuit board 1 is reduced, and thus more interface connectors 9 than those conventionally mounted (about 20 units or more) can be mounted.

Therefore, in a function requiring many interface connectors, the number of printed circuit need not be increased due to the limited number of interface connectors heretofore capable of being mounted on a single printed circuit.

Further, in a function requiring many interface connectors but having a lesser number of circuit components to be mounted, the components were conventionally mounted on only a portion of the surface of a printed circuit board and the remaining surface thereof was wasted. In this case, the wastage of the surface of the printed circuit board can be prevented by mounting the functions not requiring interface connectors, on the same printed circuit board.

As described above, In a control apparatus, there is a fact that more circuit components need an interface connector to receive an input from and transfer an output to external devices and less circuit components need the interface connector, whereas in the present intention, since a number of the Interface connectors which can be mounted are surplus, other functions requiring interface connectors can be accommodated on the same printed circuit board, and thus the use of the surface of the printed circuit board is not wasted.

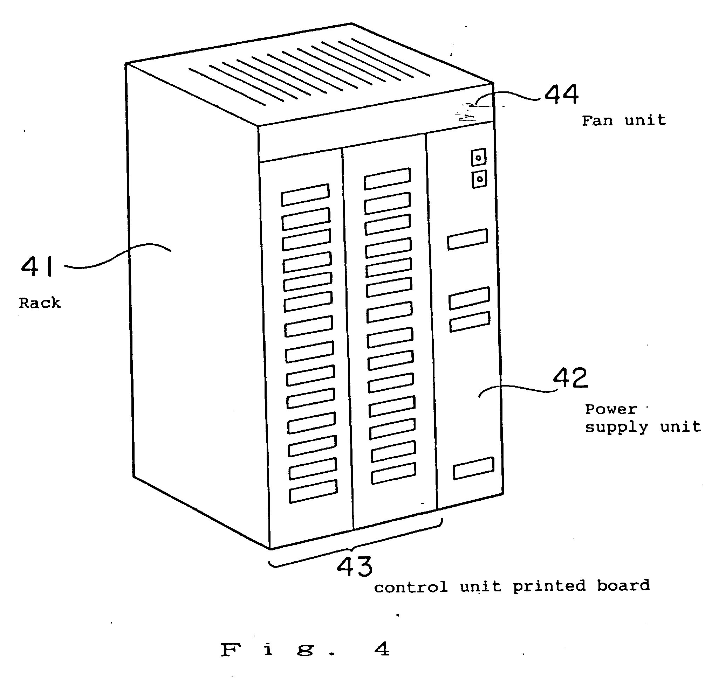

Figure 4 is a diagram showing the outside appearance of the control apparatus using the printed circuit board shown in Figure 1. A power supply unit 42 and various control unit printed boards 43 are attached to a rack 41. As shown in Figure 1, the control unit printed board 43 includes various circuit components mounted thereon, and the respective control unit printed boards 43 are interconnected through a back plane.

Many circuit components are mounted on each printed circuit board, as shown in Figure 1, and thus the mounting density thereof is greatly improved compared with that of a conventional printed circuit board. Therefore, the effect of heat generated from the circuit components cannot be ignored. Accordingly, in the present embodiment, a fan unit 44 is provided at the uppermost portion of the rack 41, to cool the respective circuit components on the printed circuit board 1. With this arrangement, the problem of heat generated due to the high density mounting can be solved.

As described above, although various functions were horizontally mounted on a relatively large printed circuit board in a prior art, in the present invention, tbe various functions are classified to a certain degree, the classified functions are arranged as modules, and the modules can be mounted vertically instead of horizontally. Further, since the components can be thus mounted on both surfaces of the module board, the mounting density thereof is increased compared with that of the conventional flat mounting.

Further, since twice as many interface connectors as conventionally used are mounted at the front edge of the printed circuit board, the limitation of the number of interface connectors is alleviated and the number of functions which can be mounted on a single printed circuit board is greatly increased, and further an increased density of the circuits is obtained due to the arrangement thereof as the module.

Further, the module board and the interface con nector have substantially the same height, and thus even if mounted on the same printed circuit board, no wasted space exists, and the volume of the control apparatus as a whole is reduced to one half the volume of the conventional control apparatus.

As described above, according to the present invention, since components constituting a control apparatus and mounted on a printed circuit board are arranged to have the same height, the space utilization efficiency is improved and the size of the control apparatus can be reduced.

## Claims

1. A control apparatus comprising a plurality of printed circuit boards (1), whereby the apparatus includes module boards (10) having circuit components (11-14) mounted thereon, the module boards (10) being mounted on the printed circuit boards (1) in such a manner that the mounting surface of each of the module boards (10) is perpendicular to the mounting surface of the printed circuit boards (1);
the apparatus being characterized by elongate I/O interface connectors (9) mounted on the printed circuit boards (1) in such a manner that the long direction thereof is perpendicular to the mounting surface of the printed circuit boards (1), wherein the height of the module boards (10) from the printed circuit boards (1) is substantially the same as the height of the interface connectors (9) from the surface of the printed circuit boards (1).

2. A control apparatus according to claim 1, wherein the module boards (10) respectively comprise small printed wiring boards which are smaller than the printed circuit boards (1).

3. A control apparatus according to claim 1 or claim 2, wherein said circuit components are mounted on both surfaces of the module boards (10).

4. A control apparatus according to any of claims 1 to 3, wherein a fan unit (44) is provided to cool the circuit components.

## Patentansprüche

1. Steuervorrichtung mit mehreren gedruckten Schaltungsplatten (1) und mit Modulplatten (10), auf denen Schaltungskomponenten (11-14) angebracht sind, die (10) derart an den gedruckten Schaltungsplatten (1) befestigt sind, daß die Befestigungsfläche jeder Modulplate (10) rechtwinklig zur Befestigungsfläche der gedruckten Schaltungsplatten (1) verläuft, gekennzeichnet durch längliche Eingangs/Ausgangs Schnittstellenverbinder (9), die auf den gedruckten Schaltungsplatten (1) derart angeordnet sind, daß deren Längsrichtung rechtwinklig zur Befestigungsfläche der gedruckten Schaltungsplatten (1) verläuft, wobei die Höhe der Modulkarten (10) über den gedruckten Schaltungsplatten (1) im wesentlichen gleich der Höhe der Schnittstellenverbinder (9) über den gedruckten Schaltungsplatten (1) ist.

2. Steuervorrichtung nach Anspruch 1, dadurch gekennzeichnet, daß die Modulplatten (10) jeweils kleine gedruckte Leiterplatten aufweisen, die kleiner sind als die gedruckten Schaltungsplatten (1).

3. Steuervorrichtung nach Anspruch 1 oder 2, dadurch gekennzeichnet daß die Schaltungskomponenten auf beiden Seiten der Modulplatten (10) angebracht sind.

4. Steuervorrichtung nach einem der Ansprüche 1 bis 3, dadurch gekennzeichnet, daß ein Gebläse (44) zum Kühlen der Schaltungskomponenten vorgesehen ist.

## Revendications

1. Appareil de commande comportant plusieurs cartes (1) à circuit imprimé, l'appareil comprenant des plaques modulaires (10) sur lesquelles sont montés des composants de circuit (11, 14), les plaques modulaires (10) étant montées sur les plaques (1) à circuit imprimé de telle manière que la surface de montage de chacune des plaques modulaires (10) est perpendiculaire à la surface de montage des plaques (1) à circuit imprimé, l'appareil étant caractérisé par des connecteurs allongés (9) d'interface entrée/sortie montés sur les plaques (1) à circuit imprimé, de telle sorte que la direction de leur longueur soit perpendiculaire à la surface de montage des plaques (1) à circuit imprimé, la hauteur des plaques modulaires (10), comptée à partir des plaques (1) à circuit imprimé étant essentiellement la même que la hauteur des connecteurs d'interface (9), comptée à partir de la surface des plaques (1) à circuit imprimé.

2. Appareil de commande selon la revendication 1, dans lequel les plaques modulaires (10) comprennent respectivement de petites plaques de câblage imprimées, qui sont plus petites que les plaques (1) à circuit imprimé.

3. Appareil de commande selon la revendication 1 ou la revendication 2, dans lequel lesdits composants de circuit sont montés sur les deux faces des plaques modulaires (10).

4. Appareil de commande selon l'une quelconque des revendications 1 à 3, dans lequel une unité de ventilateur (44) est prévue pour refroidir les composants de circuit.
